# EUROPÄISCHE PATENTANMELDUNG

(11) **EP 1 560 307 A1**
(43) Veröffentlichungstag der Anmeldung: **03.08.2005**
(21) Anmeldenummer: 05001122.0
(22) Anmeldetag: 20.01.2005
(51) Int. Cl.: H01S 5/14

(54) **Laserdioden-Anordnung mit externem Resonator**

(30) Priorität: 27.01.2004 DE 202004001230 U
(71) Anmelder: Sacher, Joachim, 35041 Marburg/Lahn (DE)
(72) Erfinder: Sacher, Joachim, 35041 Marburg/Lahn (DE)
(74) Vertreter: Buchhold, Jürgen, Dipl.-Phys.

(57) **Zusammenfassung**

Eine Laserdioden-Anordnung (10) zur Erzeugung von einmodiger, durchstimmbarer Laserstrahlung (15) hat eine Breitstreifenlaserdiode (11), die eine Rückfacette (16) und eine Frontfacette (17) aufweist und einen ersten Resonator (R1) bildet, sowie einen daran angekoppelten externen Resonator (R2), der eine optische Transmissionskomponente (30) und wenigstens ein wellenlängenselektives optisches Reflexionselement (40, 50) aufweist und von der Breitstreifenlaserdiode (11) emittiertes Laserlicht (13) in den ersten Resonator (R1) zurückkoppelt. Um bei relativ hoher Strahlqualität und kompakter Bauform eine deutlich höhere Leistungsausbeute zu erzielen und um ferner die Wellenlänge frei von Modensprüngen frei von Modensprüngen durchstimmbar durchstimmen zu können, ist vorgesehen, daß die optische Transmissionskomponente (30) eine rotationssymmetrische, insbesondere asphärische Kollimationslinse ist, die derart angeordnet und/oder ausgerichtet ist, daß das von der Breitstreifenlaserdiode (11) emittierte Laserlicht (13) in einer Raumrichtung (S) senkrecht zur Epitaxieebene (E) der Laserdiode (11) kollimiert ist. Das wellenlängenselektive optische Reflexionselement (40, 50) ist bevorzugt im Bereich der Raleigh-Länge des Fokus der optischen Transmissionskomponente (30) angeordnet.

## Beschreibung

Die Erfindung betrifft eine Laserdioden-Anordnung mit einem externen Resonator gemäß dem Oberbegriff von Anspruch 1.

Durch eine in Flußrichtung betriebene Halbleiter-Laserdiode kann mittels stimulierter Emission kohärentes Laserlicht erzeugt werden. Um die Frequenz bzw. Wellenlänge verändern zu können, kombiniert man die Halbleiter-Laserdiode mit einem externen Resonator, der über wellenlängenselektive Elemente wie Gitter und Filter nur Licht bestimmter Wellenlängen ― den Resonatormoden ― in die Laserdiode zurückkoppelt. Dies führt zu einer Verstärkung der stimulierten Emission auf der jeweils ausgewählten Wellenlänge (Einmodenbetrieb). Zugleich läßt sich über das wellenlängenselektive Element die Emissionswellenlänge über den Verstärkungsbereich der Laserdiode durchstimmen.

Ein solcher Einmodenbetrieb läßt sich mit Einstreifen-Diodenlasern meist sehr gut und zuverlässig realisieren, weil deren optisch aktive Zone (Emitter) eine Querschnittsfläche aufweist, die auf etwa 1 µm x 3 µm begrenzt ist. Zugleich ist jedoch auch die erreichbare Ausgangsleistung auf maximal 200 bis 300 mW beschränkt, was für zahlreiche Anwendungen oft nicht ausreicht.

Zur Steigerung der Ausgangsleistung ist es bekannt, die Breite des Emitters auf bis zu 600 µm zu vergrößern. Die Leistungswerte dieser sogenannten Breitstreifenlaser (Hochleistungs-Laserdioden) lassen sich dadurch auf über 10 W erhöhen. Von Nachteil hierbei ist aber, daß die Laserdiode in lateraler Richtung, d.h. parallel zur Epitaxieebene, mehrmodig anschwingt, so daß die Steigerung der Ausgangsleistung eine stark inkohärente Lichtemission zur Folge hat. Senkrecht zur Epitaxieebene, d.h. in transversaler Richtung, weist die Laserdiode eine beugungsbegrenzte Strahlqualität auf.

Um dem zu begegnen, verwenden S. Wolff et.al. in "Intracavity stabilization of broad aera lasers by structured delayed optical feedback" (OPTIC EXPRESS, Vol. 7, No. 6, 11.09.2000) zur Stabilisierung der Lichtemission eines Breitstreifenlasers einen miniaturisierten externen Resonator mit einem konvexen Spiegel, der nur achsparallele Strahlen in die aktive Zone der Laserdiode rückkoppelt. Der Spiegel ― ein mit Silber beschichteter Glasstab ― liegt nur wenige Millimeter vor der Frontfacette der Laserdiode, die mit einer Antireflexionsschicht versehen ist. Die Rückfacette ist mit einer hoch-reflektierenden Schicht verspiegelt. Die Emitterschicht hat eine Querschnittsfläche von 1 µm x 100 µm. Eine zwischen der Frontfacette und dem konvexen Spiegel angeordnete Mikro-Zylinderlinse dient als Kollimator. Nachteilig hierbei ist, daß eine solche Anordnung trotz aufwendiger Optik nicht durchstimmbar ist.

WO 03/055018 offenbart eine Vorrichtung zur Erzeugung von Laserstrahlung mit einem kantenemittierenden Breitstreifenlaser in einem externen, instabilen Resonator. Letzterer besitzt ein reflektierendes Element, das keinen Einfluß auf die Divergenz des aus dem Halbleiter austretenden Lichts hat und in einem solchen Abstand vom Halbleiter angeordnet ist, daß das aus dem Halbleiter austretende divergente Licht teilweise auf den Halbleiter zurückreflektiert wird. Von diesem teilweise reflektierten Laserlicht wird wiederum nur ein Teil über eine Eintritts-/Austrittsöffnung in den Halbleiterchip eingekoppelt, so daß der Wirkungsgrad insgesamt gering ist. Überdies kommt auch diese Vorrichtung nicht ohne weitere optische Komponenten aus. So ist beispielsweise zwischen dem Halbleiterlaser und dem reflektierenden Element eine Zylinderlinse mit kurzer Brennweite angeordnet, um die bei Breitstreifenlaserdioden typische hohe Divergenz senkrecht zur Ebene der Epitaxie zu reduzieren.

Damit besteht insgesamt das Problem, daß zur Verbesserung der Strahlqualität von Breitstreifenlasern komplizierte und aufwendige Optiken erforderlich sind, die in der Anschaffung relativ teuer sind. Darüber hinaus sind derartige Resonatoranordnungen nur bedingt für den Einsatz in rauhen Industrieumgebungen oder im Weltraum geeignet, weil die zahlreichen optischen Elemente anfällig gegen Erschütterungen und Temperaturschwankungen sind. Eine Dejustierung des Resonators ist die Folge, ein Nachjustieren jedoch nicht immer möglich.

Im Bereich der Einstreifen-Diodenlasern sind bereits Resonatoren bekannt, die justageinvariant ausgebildet sind. EP-A2-0 347 213 schlägt beispielsweise ein Laserdiodensystem mit externem Resonator in Littrow-Anordnung vor, das neben einer Kollimationsoptik und einem Beugungsgitter einen anamorphotischen Übertragungsbereich aufweist, der den Laserstrahl derart formt, daß er auf dem Beugungsgitter einen Linienfokus bildet. Hierzu ist hinter der Kollimationslinse eine zylindrische Sammellinse angeordnet, deren optische Achse senkrecht zu den Gitterlinien des Resonatorgitters liegt. Zusätzliche Prismen dienen als Strahlaufweiter, um die Breite des Laserstrahls weiter zu erhöhen.

Eine solche Vorrichtung leidet ebenfalls unter der Vielzahl der optischen Bauelemente und der hieraus resultierenden Baugröße. Eine Miniaturisierung der Vorrichtung erscheint aufgrund der Qualitätsprobleme bei der Herstellung kurzbrennweitiger Zylinderlinsen nur schwer möglich. Hinzu kommt, daß eine derartige Anordnung nicht ohne weiteres auf Breitstreifenlaser übertragbar ist.

Ziel der Erfindung ist es, diese und weitere Nachteile des Stand der Technik zu überwinden und eine Laserdioden-Anordnung mit einer Breitstreifenlaserdiode und einem externen Resonator zu schaffen, die eine hohe Leistungsausbeute bei relativ hoher Strahlqualität und kompakter Bauform ermöglicht. Angestrebt wird insbesondere die Erzeugung von einmodigem Laserlicht, dessen Wellenlänge kontinuierlich und frei von Modensprüngen durchstimmbar ist. Der Aufbau soll mit einfachen Mitteln kostengünstig realisierbar und leicht zu handhaben sein. Die Abbildungseigenschaften des externen Resonators sollen justageinvariant sein.

Hauptmerkmale der Erfindung sind im kennzeichnenden Teil von Anspruch 1 angegeben. Ausgestaltungen sind Gegenstand der Ansprüche 2 bis 21.

Bei einer Laserdioden-Anordnung zur Erzeugung von einmodiger, durchstimmbarer Laserstrahlung, mit einer Breitstreifenlaserdiode, die eine Rückfacette und eine Frontfacette aufweist und einen ersten Resonator bildet, und mit einem daran angekoppelten externen Resonator, der eine optische Transmissionskomponente und wenigstens ein wellenlängenselektives optisches Reflexionselement aufweist und von der Breitstreifenlaserdiode emittiertes Laserlicht in den ersten Resonator zurückkoppelt, sieht die Erfindung laut Anspruch 1 vor, daß die optische Transmissionskomponente eine rotationssymmetrische Kollimationslinse ist, die derart angeordnet und/oder ausgerichtet ist, daß das von der Breitstreifenlaserdiode emittierte Laserlicht in einer Raumrichtung senkrecht zur Epitaxieebene der Breitstreifenlaserdiode kollimiert ist.

Aufgrund der Geometrie des Emitters zeigen Breitstreifenlaserdioden transversal, d.h. in Richtung senkrecht zur Epitaxieebene, einen Abstrahlwinkel von etwa 30 ° und lateral, d.h. in Richtung parallel zur Epitaxieebene einen Abstrahlwinkel von etwa 5 °. Es hat sich daher überraschend gezeigt, daß die Verwendung einer einfachen rotationssymmetrischen Kollimationslinse in Kombination mit einer Breitstreifenlaserdiode dazu führt, daß in einer Raumrichtung parallel zur Ebene der Epitaxie in definiertem Abstand zur Frontfacette der Laserdiode auf dem wellenlängenselektiven optischen Reflexionselement ein Linienfokus erzeugt werden kann. Dadurch wird der Resonator gegenüber der Rotation des wellenlängenselektiven Reflexionselements mit einer Rotationsachse senkrecht zur Epitaxieebene der Laserdiode justageinvariant. Eine Rotation des wellenlängenselektiven Reflexionselements um eine Achse parallel zur Epitaxieebene führt hingegen zur Abstimmung der Emissionswellenlänge.

Die gesamte Laseranordnung läßt sich äußerst kompakt und robust ausbilden, d.h. sie hält mechanischen Stößen und Vibrationen problemlos stand. Selbst der Einsatz in meist rauhen industriellen Umgebungen oder im Weltraum ist möglich. Das von dem wellenlängenselektiven Element rückgekoppelte Licht wird stets exakt auf die lichtemittierende Laserfacette fokussiert, so daß auch auf Dauer weder Modensprünge noch Leistungsverluste auftreten. Aufwendige Ausgleichsmechaniken sind nicht erforderlich. Der Wirkungsgrad ist relativ hoch.

Weil der Linienfokus ausschließlich durch Abbildung der Laserdiodenfacette mit der rotationssymmetrischen Kollimationslinse erzeugt wird, die gemäß Anspruch 2 vorzugsweise eine asphärische Linse ist, sind weitere oder zusätzliche optische Komponenten, z.B. eine Zylinderlinse, nicht erforderlich. Mithin ist es auf einfache und kostengünstige Art möglich, einmodige, modensprungfrei durchstimmbare Laserstrahlung mit hoher Ausgangsleistung zu erzeugen.

Dazu trägt auch Anspruch 3 bei, wenn nämlich das wellenlängenselektive optische Reflexionselement im Bereich der Raleigh-Länge des Fokus der optischen Transmissionskomponente angeordnet ist. Dadurch ergibt sich ein stets stabiler optischer Resonator.

Eine weitere Leistungssteigerung wird durch die Maßnahme von Anspruch 4 erreicht, wonach die Laserstrahlung über die Rückfacette der Breitstreifenlaserdiode auskoppelbar ist und das Verhältnis der Reaktivität der Rückfacette zur Reflektivität des optischen Reflexionselements sehr viel kleiner als 1 beträgt. Hierdurch werden auch Schwankungen der Lichtleistung und Modensprünge in der spektralen Durchstimmkurve des Lasersystems wirksam vermieden. Anspruch 5 sieht in diesem Zusammenhang vor, daß das Verhältnis der Reflektivität der Rückfacette zur Reflektivität des optischen Reflexionselements kleiner als 0,1 ist. Gemäß Anspruch 6 ist die Reflektivität der Rückfacette bevorzugt kleiner oder gleich 1 % und die Reflektivität des optischen Reflexionselements größer oder gleich 95 %. Diese Werte lassen sich einfach und kostengünstig realisieren.

In der Ausbildung von Anspruch 7 ist im Bereich der Rückfacette der Breitstreifenlaserdiode eine weitere optische Transmissionskomponente angeordnet, wobei diese laut Anspruch 8 bevorzugt eine Kollimationslinse aufweist. Zusätzlich kann man laut Anspruch 9 eine Zylinderlinse vorsehen, so daß der Ausgangsstrahl der Laserdioden-Vorrichtung den jeweiligen Erfordernissen entsprechend angepaßt werden kann.

Für eine optimale Ankopplung des externen Resonators an den von der Laserdiode gebildeten Resonator ist die Frontfacette der Breitstreifenlaserdiode gemäß Anspruch 10 mit einer Antireflexionsbeschichtung versehen, wobei deren Reflektivität in Einklang mit Anspruch 11 kleiner als 0,1 % beträgt.

Das wellenlängenselektive Reflexionselement ist laut Anspruch 12 bevorzugt ein optisches Beugungsgitter und/oder gemäß Anspruch 13 ein Spiegel. Dementsprechend kann die Breitstreifenlaserdiode und der externe Resonator nach Anspruch 14 eine Littman- oder eine Littrow-Anordnung bilden.

In vorteilhafter Weiterbildung der Erfindung hat die Breitstreifenlaserdiode gemäß Anspruch 15 eine aktive Zone, die parallel zur Epitaxieebene eine rechteckige Form aufweist. Die Querschnittsfläche dieser aktiven Zone besitzt senkrecht zur Epitaxieebene eine Breite zwischen 5 µm und 600 µm (Anspruch 16).

Alternativ kann die Breitstreifenlaserdiode nach Anspruch 17 eine aktive Zone aufweisen, die parallel zur Epitaxieebene eine trapezförmige Form bildet. Dies verhindert das Anschwingen von räumlichen Moden, wodurch die Strahlqualität weiter verbessert wird. Die Querschnittsfläche der aktiven Zone weist an der Frontfacette senkrecht zur Epitaxieebene laut Anspruch 18 eine Breite zwischen 5 µm und 300 µm auf, so daß auch hier hohe Leistungsausbeuten möglich sind.

Eine weitere Leistungssteigerung erreicht man, wenn die Breitstreifenlaserdiode gemäß Anspruch 19 von einem Laserdioden-Array bzw. Barren gebildet wird.

In der Ausbildung von Anspruch 20 ist die Laserdiode ein Quantenpunktlaser. Oder man verwendet für die Herstellung der Laserdiode in Einklang mit Anspruch 21 ein Lasermaterial aus Dilute-Nitrid-Arsenid. Beides eröffnet auf wirtschaftliche Weise die Nutzung größerer oder anders gelagerter Wellenlängenbereiche.

Weitere Merkmale, Einzelheiten und Vorteile der Erfindung ergeben sich aus dem Wortlaut der Ansprüche sowie aus der folgenden Beschreibung von Ausführungsbeispielen anhand der Zeichnungen. Es zeigen:
- Fig. 1: eine schematische Draufsicht auf eine Laserdioden-Anordnung in Littman-Anordnung,
- Fig. 2: die Laserdioden-Anordnung von Fig. 1 in einer Seitenansicht,
- Fig. 3: eine schematische Draufsicht auf eine Laserdioden-Anordnung in Littrow-Anordnung und
- Fig. 4: die Laserdioden-Anordnung von Fig. 3 in einer Seitenansicht,

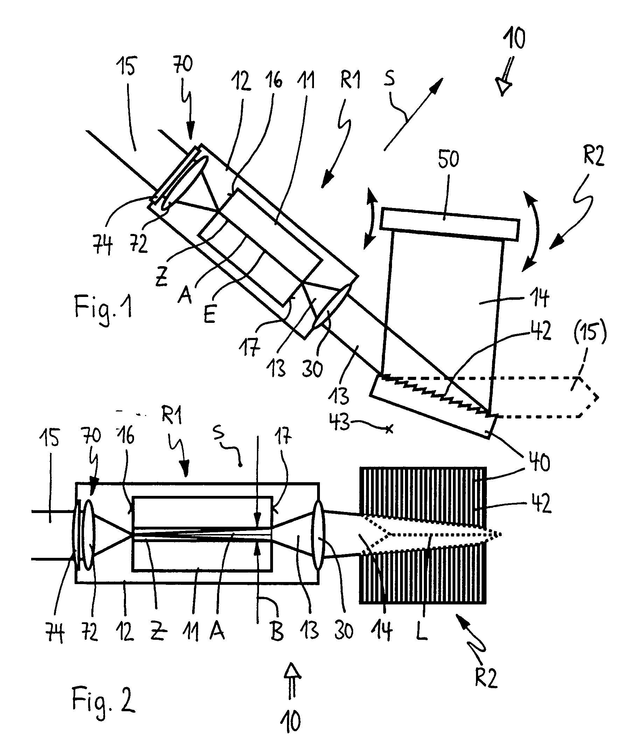

Die in Fig. 1 allgemein mit 10 bezeichnete Laserdioden-Anordnung zur Erzeugung von einmodiger, durchstimmbarer Laserstrahlung 15 ist als Littman-Anordnung ausgebildet. Sie umfaßt eine Breitstreifenlaserdiode 11, die auf einem Träger 12, z.B. einer Grundplatte oder einem Montageblock, befestigt ist. Die Rückfacette 16 und die Frontfacette 17 der Laserdiode 11 bilden die Endflächen eines ersten Resonators R1, dessen Länge von der (nicht näher bezeichneten) Länge des Halbleiterkristalls der Breitstreifenlaserdiode 11 bestimmt wird. Die Frontfacette 17 ist zur besseren Ankopplung des externen Resonators R2 an den ersten Resonator R1 mit einer Antireflexionsbeschichtung versehen, deren Reflektivität kleiner als 0,1 % beträgt.

Die Breitstreifenlaserdiode 11 hat eine aktive Zone Z, die parallel zur Epitaxieebene E eine rechteckige Form aufweist. Die Querschnittsfläche der aktiven Zone Z senkrecht zur Epitaxieebene E besitzt eine Höhe von 1µm und eine Breite B von 500 µm, so daß die Laserdiode 11 eine Ausgangsleistung von über 10 W erreichen kann.

Das von der Laserfacette 17 emittierte Laserlicht 13 wird von einer optischen Transmissionskomponente 30 in Form einer rotationssymmetrischen asphärischen Kollimationslinse auf die Oberfläche eines optischen Beugungsgitters 40 fokussiert, das als wellenlängenselektives Reflexionselement zusammen mit einem Spiegel 50 Bestandteil eines externen Resonators R2 ist. Die Reflektivität des planen Gitters 40 beträgt vorzugsweise etwa 95 %, so daß ein Großteil des Laserlichts 14 der ersten Beugungsordnung von dem Gitter 40 auf den Spiegel 50 gelenkt wird. Von dort wird das Licht zurückreflektiert und ― nachdem es von dem Gitter 40 ein zweites Mal gebeugt wurde- in die Breitstreifenlaserdiode 11 zurückgekoppelt.

Man erkennt in Fig. 2, daß die rotationssymmetrische asphärische Kollimationslinse 30 derart angeordnet bzw. ausgerichtet ist, daß das von der Breitstreifenlaserdiode 11 emittierte Laserlicht 13 in einer Raumrichtung S senkrecht zur Epitaxieebene E der Laserdiode 11 kollimiert wird. Dadurch entsteht auf dem optischen Beugungsgitter 40 senkrecht zu den Gitterlinien 42 ein Linienfokus L, d.h. das von der Laserfacette 17 emittierte Laserlicht 13 wird von der Transmissionskomponente 30 als schmale Linie L auf dem Gitter 40 abgebildet, wobei die Höhe der Linie sehr viel kleiner ist als deren Breite. Letztere bestimmt die Selektivität des Gitters 40.

Durch diese ebenso einfach wie kostengünstig zu realisierende Anordnung wird die Laser-Anordnung 10 insgesamt justageinvariant gegenüber Verkippungen des Gitters 40 um eine Achse senkrecht zu den Gitterlinien 42, die beispielsweise beim Verschwenken des Gitters 40 um die Achse 43 oder durch Erschütterungen entstehen können. Überdies treten keine durch die Resonatoroptik 30, 40, 50 bedingten Leistungsverluste auf, weil die Abbildungseigenschaften des äußerst kompakt realisierbaren Resonators R2 stets optimal sind. Folglich bleibt das Abstimmverhalten der Laser-Anordnung 10 beim Verschwenken des Gitters 40 um die Achse 43 voll erhalten. Die Leistungsausbeute der Breitstreifenlaserdiode 11 ist stets optimal; der Wirkungsgrad der Laser-Anordnung 10 insgesamt sehr hoch.

Um einen stabilen externen Resonator R2 zu erhalten, ist das Gitter 40 im Bereich der Raleigh-Länge des Fokus der rotationssymmetrischen asphärischen Kollimationslinse 30 angeordnet. Es sitzt bevorzugt auf einem (nicht dargestellten) Träger, der mittels (ebenfalls nicht gezeigter) Justier- bzw. Stellmittel, z.B. einem Verschiebetisch, um wenigstens eine Achse 43 parallel zu den Gitterlinien 42 verschwenkt und/oder in verschiedenen Raumrichtungen linear verschoben werden kann. Die Gitterlinien 42 des Gitters 40 verlaufen dabei senkrecht zur Längsachse A der Breitstreifenlaserdiode 11.

Der Spiegel 50 ist auf einem (ebenfalls nicht gezeichneten) Tragarm befestigt, der um eine Achse 54 schwenkbar gelagert ist. Letztere verläuft parallel zur Spiegelebene. Wird der Tragarm um die Achse 54 verschwenkt, ändert sich die von dem Gitter 40 in die Laserdiode 11 zurückgekoppelte Wellenlänge. Der Laser 10 wird verstimmt. Gleichzeitig ändert sich die durch die Länge des externen Resonators R2 bestimmte Wellenlänge, was jedoch durch eine entsprechende Verschiebung des Gitters 40 relativ zum Spiegel 50 bzw. relativ zu dessen Drehachse 54 unter Einbeziehung mehrerer Dispersionsordnungen ausgeglichen werden kann (siehe hierzu beispielsweise DE-U1-296 06 494).

Die Auskopplung der Laserstrahlung 15 erfolgt bevorzugt über die Rückfacette 16 der Breitstreifenlaserdiode 11, die hierzu mit einer Reflektivität von kleiner oder gleich 1 % versehen ist, d.h. das Verhältnis der Reflektivität der Rückfacette 16 zur Reflektivität des optischen Gitters 40 ist sehr viel kleiner als 1, vorzugsweise sehr viel kleiner als 0,1. Dadurch erreicht man eine weitere Leistungssteigerung, weil von dem externen Resonator R2 sehr viel mehr Licht in die Breitstreifenlaserdiode 11 zurückgekoppelt wird.

Für eine gezielte Nutzung der von der Laserdioden-Anordnung 10 emittierten Laserstrahlung 15 ist im Bereich der Rückfacette 16 eine optische Transmissionskomponente 70 angeordnet, die von einer Kollimationslinse 72 und einer nachgeschalteten Zylinderlinse 74 gebildet wird. Auf diese Weise kann der Laserstrahl 15 in geeigneter Weise geformt werden.

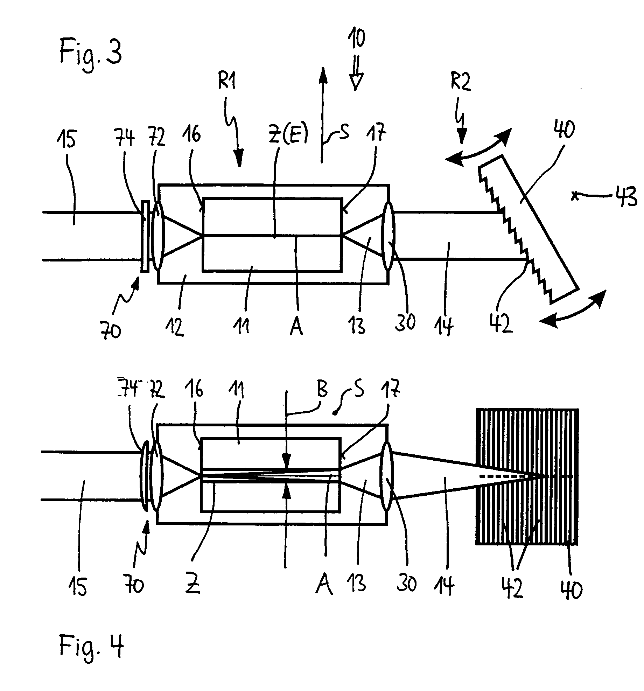

In der Ausführungsform von Fig. 3 und 4 bildet die Laserdioden-Anordnung 10 eine Littrow-Anordnung. Diese besteht im wesentlichen aus der Breitstreifenlaserdiode 11 und dem externen Resonator R2, der von der optischen Transmissionskomponente 30 in Form einer rotationssymmetrischen asphärischen Kollimationslinse und dem wellenlängenselektiven optischen Reflexionselement 40 in Form eines planen Beugungsgitters als Resonatorendspiegel gebildet wird. Die Auskopplung des Laserlichts 15 erfolgt auch hier über die Rückfacette 16 der Breitstreifenlaserdiode 11.

Die Erfindung ist nicht auf eine der vorbeschriebenen Ausführungsformen beschränkt, sondern in vielfältiger Weise abwandelbar.

So kann die Breitstreifenlaserdiode 11 eine aktive Zone Z aufweisen, die parallel zur Epitaxieebene E eine trapezförmige Form aufweist, wobei die Querschnittsfläche der aktiven Zone Z an der Frontfacette 17 senkrecht zur Epitaxieebene E eine Breite B zwischen 5 µm und 300 µm aufweist. Auf diese Weise kann man bei relativ hoher Ausgangsleistung das Anschwingen von räumlichen Moden verhindern.

Eine weitere Leistungssteigerung ergibt sich, wenn die Breitstreifenlaserdiode 11 von einem (nicht näher gezeigten) Laserdioden-Array bzw. Barren gebildet wird.

In einer noch anderen Ausführungsform kann man das Laserlicht 15 auch über das Gitter 40 auskoppeln. In diesem in Fig. 1 mit gestrichelten Linien angedeuteten Fall erhält die Rückfacette 16 der Breitstreifenlaserdiode 11 eine Reflektivität von etwa 95 % und das Gitter 40 eine Reaktivität von etwa 5 %.

Ferner kann man als Laserdiode einen Quantenpunktlaser verwenden. Oder man verwendet für die Herstellung der Laserdiode Dilute-Nitrid-Arsenid als Lasermaterial. Hierdurch lassen sich größere oder anders gelagerte Wellenlängenbereiche erschließen.

Man erkennt, daß eine Laserdioden-Anordnung 10 zur Erzeugung von einmodiger, durchstimmbarer Laserstrahlung 15 eine Breitstreifenlaserdiode 11 hat, die eine Rückfacette 16 und eine Frontfacette 17 aufweist und ferner einen ersten Resonator R1 bildet. Einen daran angekoppelter externer Resonator R2 weist eine optische Transmissionskomponente 30 und wenigstens ein wellenlängenselektives optisches Reflexionselement 40, 50 auf, wodurch das von der Breitstreifenlaserdiode 11 emittiertes Laserlicht 13 in den ersten Resonator R1 zurückkoppelt wird. Um bei relativ hoher Strahlqualität und kompakter Bauform eine deutlich höhere Leistungsausbeute zu erzielen und um ferner die Wellenlänge frei von Modensprüngen frei von Modensprüngen durchstimmbar durchstimmen zu können, ist vorgesehen, daß die optische Transmissionskomponente 30 eine rotationssymmetrische, insbesondere asphärische Kollimationslinse ist, die derart angeordnet und/oder ausgerichtet ist, daß das von der Breitstreifenlaserdiode 11 emittierte Laserlicht 13 in einer Raumrichtung S senkrecht zur Epitaxieebene E der Laserdiode 11 kollimiert ist. Das wellenlängenselektive optische Reflexionselement 40, 50 ist bevorzugt im Bereich der Raleigh-Länge des Fokus der optischen Transmissionskomponente 30 angeordnet

Sämtliche aus den Ansprüchen, der Beschreibung und der Zeichnung hervorgehenden Merkmale und Vorteile, einschließlich konstruktiver Einzelheiten, räumlicher Anordnungen und Verfahrensschritten, können sowohl für sich als auch in den verschiedensten Kombinationen erfindungswesentlich sein.

### Bezugszeichenliste

- A: Längsachse (Laserdiode)
- B: Breite (Emitter)
- E: Epitaxieebene
- L: Linienfokus
- R1: Resonator
- R2: externer Resonator
- S: Raumrichtung
- Z: Aktive Zone

- 10: Laserdioden-Anordnung
- 11: Breitstreifenlaserdiode
- 12: Träger
- 13: Laserstrahlung
- 14: Laserstrahlung
- 15: Laserlicht / Nutzstrahl
- 16: Rückfacette
- 17: Frontfacette
- 30: optische Transmissionskomponente

- 40: optisches Reflexionselement / Gitter
- 42: Gitterlinien
- 43: Drehachse

- 50: Spiegel
- 54: Drehachse

- 70: weitere optische Transmissionskomponente
- 72: Kollimator / asphärische Linse
- 74: Zylinderlinse

## Patentansprüche

1. Laserdioden-Anordnung (10) zur Erzeugung von einmodiger, durchstimmbarer Laserstrahlung (15), mit einer Breitstreifenlaserdiode (11), die eine Rückfacette (16) und eine Frontfacette (17) aufweist und einen ersten Resonator (R1) bildet, und mit einem daran angekoppelten externen Resonator (R2), der eine optische Transmissionskomponente (30) und wenigstens ein wellenlängenselektives optisches Reflexionselement (40, 50) aufweist und von der Breitstreifenlaserdiode (11 ) emittiertes Laserlicht (13) in den ersten Resonator (R1) zurückkoppelt, **dadurch gekennzeichnet, daß** die optische Transmissionskomponente (30) eine rotationssymmetrische Kollimationslinse ist, die derart angeordnet und/oder ausgerichtet ist, daß das von der Breitstreifenlaserdiode (11) emittierte Laserlicht (13) in einer Raumrichtung (S) senkrecht zur Epitaxieebene (E) der Laserdiode (11) kollimiert ist.

2. Anordnung nach Anspruch 1, **dadurch gekennzeichnet, daß** die optische Transmissionskomponente (30) eine asphärische Linse ist.

3. Anordnung nach Anspruch 1 oder 2, **dadurch gekennzeichnet, daß** das wellenlängenselektive optische Reflexionselement (40, 50) im Bereich der Raleigh-Länge des Fokus der optischen Transmissionskomponente (30) angeordnet ist.

4. Anordnung nach einem der Ansprüche 1 bis 3, **dadurch gekennzeichnet, daß** die Laserstrahlung (15) über die Rückfacette (16) der Breitstreifenlaserdiode (11 ) auskoppelbar ist, wobei das Verhältnis der Reflektivität der Rückfacette (16) zur Reflektivität des optischen Reflexionselements (40) sehr viel kleiner als 1 ist.

5. Anordnung nach Anspruch 4, **dadurch gekennzeichnet, daß** das Verhältnis der Reflektivität der Rückfacette (16) zur Reflektivität des optischen Reflexionselements (40) kleiner als 0,1 ist.

6. Anordnung nach Anspruch 4 oder 5, **dadurch gekennzeichnet, daß** die Reflektivität der Rückfacette (16) kleiner oder gleich 1 % und die Reflektivität des optischen Reflexionselements (40) größer oder gleich 95 % ist.

7. Anordnung nach einem der Ansprüche 4 bis 6, **dadurch gekennzeichnet, daß** im Bereich der Rückfacette (16) der Breitstreifenlaserdiode (11) eine weitere optische Transmissionskomponente (70) angeordnet.

8. Anordnung nach Anspruch 7, **dadurch gekennzeichnet, daß** die weitere optische Transmissionskomponente (70) eine Kollimationslinse (72) aufweist.

9. Anordnung nach Anspruch 7 oder 8, **dadurch gekennzeichnet, daß** die weitere optische Transmissionskomponente (70) eine Zylinderlinse (74) aufweist.

10. Anordnung nach einem der Ansprüche 1 bis 9, **dadurch gekennzeichnet, daß** die dem externen Resonator (R2) zugewandte Frontfacette (17) der Breitstreifenlaserdiode (11) mit einer Antireflexionsbeschichtung versehen ist.

11. Anordnung nach Anspruch 10, **dadurch gekennzeichnet, daß** die Reflektivität der antireflexionsbeschichteten Frontfacette (17) kleiner als 0,1 % beträgt.

12. Anordnung nach einem der Ansprüche 1 bis 11, **dadurch gekennzeichnet, daß** das wellenlängenselektive Reflexionselement (40) ein optisches Beugungsgitter ist.

13. Anordnung nach einem der Ansprüche 1 bis 12, **dadurch gekennzeichnet, daß** das wellenlängenselektive Reflexionselement (50) ein Spiegel ist.

14. Anordnung nach einem der Ansprüche 1 bis 13, **dadurch gekennzeichnet, daß** die Breitstreifenlaserdiode (11) und der externe Resonator (R2) eine Littman- oder eine Littrow-Anordnung bilden.

15. Anordnung nach einem der Ansprüche 1 bis 14, **dadurch gekennzeichnet, daß** die Breitstreifenlaserdiode (11) eine aktive Zone (Z) hat, die parallel zur Epitaxieebene (E) eine rechteckige Form aufweist.

16. Anordnung nach Anspruch 15, **dadurch gekennzeichnet, daß** die Querschnittsfläche der aktiven Zone (Z) senkrecht zur Epitaxieebene (E) eine Breite zwischen 5 µm und 600 µm aufweist.

17. Anordnung nach einem der Ansprüche 1 bis 14, **dadurch gekennzeichnet, daß** die Breitstreifenlaserdiode (11) eine aktive Zone (Z) hat, die parallel zur Epitaxieebene (E) eine trapezförmige Form aufweist.

18. Anordnung nach Anspruch 17, **dadurch gekennzeichnet, daß** die Querschnittsfläche der aktiven Zone (Z) an der Frontfacette (17) senkrecht zur Epitaxieebene (E) eine Breite zwischen 5 µm und 300 µm aufweist.

19. Anordnung nach einem der Ansprüche 1 bis 18, **dadurch gekennzeichnet, daß** die Breitstreifenlaserdiode (11) von einem Laserdioden-Array bzw. Barren gebildet ist.

20. Anordnung nach einem der Ansprüche 1 bis 19, **dadurch gekennzeichnet, daß** die Laserdiode (11) ein Quantenpunktlaser ist

21. Anordnung nach einem der Ansprüche 1 bis 19, **dadurch gekennzeichnet, daß** die Laserdiode (11) aus Dilute-Nitrid-Arsenid hergestellt ist.
